# EUROPEAN PATENT SPECIFICATION

(11) **EP 4 290 586 B1**
(45) Date of publication and mention of the grant of the patent: **18.11.2026**
(21) Application number: 22749854.0
(22) Date of filing: 07.02.2022
(51) Int. Cl.: H10D 30/67

(54) **THIN-FILM TRANSISTOR AND METHOD FOR MANUFACTURING THIN-FILM TRANSISTOR**
DÜNNSCHICHTTRANSISTOR UND VERFAHREN ZUR HERSTELLUNG EINES DÜNNSCHICHTTRANSISTORS
TRANSISTOR À COUCHES MINCES ET PROCÉDÉ DE FABRICATION DE TRANSISTOR À COUCHES MINCES

(30) Priority: 08.02.2021 JP 2021018151
(43) Date of publication of application: 13.12.2023
(73) Proprietor: TOPPAN INC., Tokyo 110-0016 (JP)
(72) Inventor: IMAMURA, Chihiro, Tokyo 110-0016 (JP); ITO, Manabu, Tokyo 110-0016 (JP); TANAKA, Yukikazu, Tokyo 110-0016 (JP)
(74) Representative: Plasseraud IP
(86) International application number: PCT/JP2022/004765
(87) International publication number: WO 2022/168983

(56) References cited:
- WO-A1-2014/196107
- JP-A- 2009 246 342
- KR-A- 20080 065 517
- KR-B1- 100 857 455
- US-A1- 2015 102 344
- US-A1- 2015 129 864
- US-A1- 2015 228 674
- US-A1- 2017 294 456
- US-A1- 2018 040 739

## Description

### [Technical Field]

The present disclosure relates to a thin film transistor including, as a gate insulating layer, a laminate of a first gate insulating film made of an organic polymer compound and a second gate insulating film made of an inorganic silicon compound, and a method for manufacturing the thin film transistor.

### [Background Art]

A thin film transistor having a gate insulating layer including an organic polymer compound film and an inorganic silicon compound film combines a good withstand voltage and flexibility.

With the aim of improving the electrical properties of the thin film transistor and improving the adhesion between the layers in the thin film transistor, it has been proposed to control a dielectric property value of the gate insulating layer (= (ε_{A}/d_{A})/(ε_{B}/d_{B})) to 0.015 or more and 1.0 or less (see, for example, PTL 1).

The relative permittivity ε_{A} used to calculate the dielectric property value is the relative permittivity of the first gate insulating film containing the organic polymer compound.

The thickness d_{A} is the thickness of the first gate insulating film.

The relative permittivity ε_{B} used to calculate the dielectric property value is the relative permittivity of the second gate insulating film containing the inorganic silicon compound.

The thickness d_{B} is the thickness of the second gate insulating film.

Document US2015129864 discloses an organic-inorganic hybrid transistor of the related art. Document US2015/228674 discloses a thin film transistor which is provided with an oxide semiconductor thin film layer and has a threshold voltage that does not change much due to light, a bias stress or the like, thereby exhibiting excellent stress stability.

### [Citation List]

### [Patent Literature]

[PTL 1] JP 2010-21264 A

### [Summary of the Invention]

### [Technical Problem]

The relative permittivity of the gate insulating layer is an index value indicating whether the amount of charge induced per unit area can be secured. It is also an index value indicating whether the current leakage between the gate electrode and another electrode can be suppressed. On the other hand, the relative permittivity of the gate insulating layer is not closely related to the electrical durability against bending of the flexible substrate.

Similarly, the above-described dielectric property value, which compares the susceptibility to dielectric polarization of the first gate insulating film to that of the second gate insulating film, is also not closely related to the electrical durability against bending of the flexible substrate. As a result, when the configuration has a relative permittivity within a predetermined range, or even when the configuration has a dielectric property value within the predetermined range, it may not be possible to increase the electrical durability against bending of the flexible substrate.

### [Solution to Problem]

Thin film transistors for solving the above problems are defined in the appended claims.

According to the above thin film transistors, it is possible to reduce the variation in threshold voltage and increase the field-effect mobility of the semiconductor layer. Further, it is possible to suppress the change in field-effect mobility caused by bending of the flexible substrate.

Methods of manufacturing a thin film transistor for solving the above problems are also provided.

According to the above methods of manufacturing thin film transistors, it is possible to reduce variation in threshold voltage and increase the field-effect mobility of the semiconductor layer. Further, it is possible to suppress the change in field-effect mobility caused by bending of the flexible substrate.

### [Advantageous Effects of the Invention]

According to the above structures, it is possible to improve the electrical durability of a thin film transistor against bending of the flexible substrate.

### [Brief Description of the Drawings]

Fig. 1 is a cross-sectional view showing a first example of a multilayer structure of a thin film transistor.
Fig. 2 is a cross-sectional view showing a second example of a multilayer structure of a thin film transistor.
Fig. 3 is cross-sectional view of a thin film transistor according to a comparative example.
Fig. 4 is a scatter plot showing the relationship of the rate of decrease in mobility to the thickness and hydrogen content.
Fig. 5 is a scatter plot showing the relationship of the rate of decrease in mobility to the thickness and dielectric property value.
Fig. 6 is a table showing the relationship between the layer structure of each example and the rate of decrease in mobility.
Fig. 7 is a table showing the relationship between the layer structure of each comparative example and the rate of decrease in mobility.

### [Description of the Embodiments]

An embodiment of a thin film transistor and an embodiment of a method of manufacturing a thin film transistor will be described below. First, the multilayer structure of the thin film transistor will be described, then the constituent materials and dimensions of each layer of the thin film transistor will be described, and finally the method of manufacturing the thin film transistor will be described.

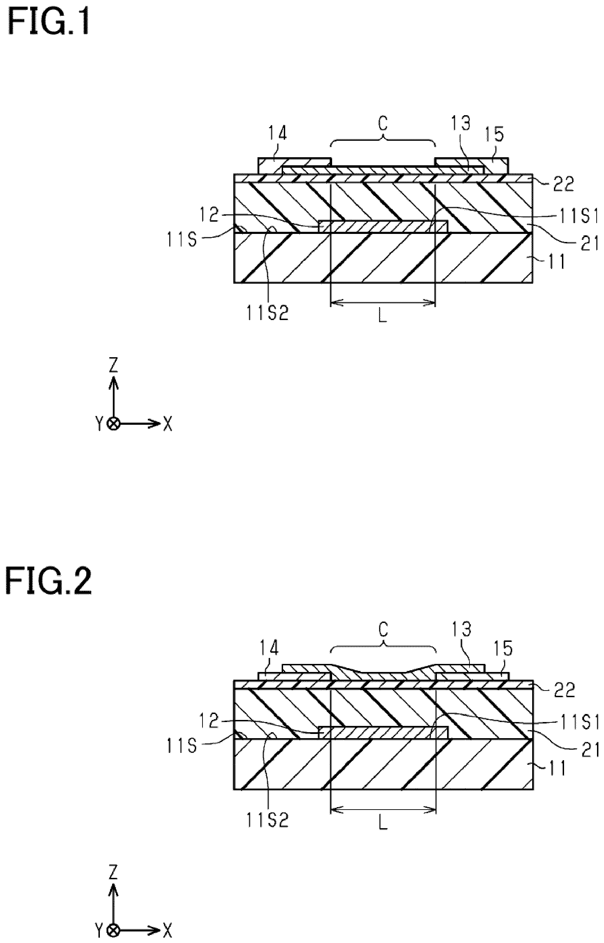

Fig. 1 shows a first example of the multilayer structure of a thin film transistor. Fig. 2 shows a second example of the multilayer structure of a thin film transistor. In the following, the upper and lower surfaces of each component of the thin film transistor will be described assuming it is oriented as in Figs. 1 and 2.

In addition, since the source and the drain in the thin film transistor are determined according to the operation of the driver circuit of the thin film transistor, one electrode layer may have its function changed from source to drain, and another electrode layer may have its function changed from drain to source.

### [Multilayer Structure]

As shown in Fig. 1, the first example of a thin film transistor is a bottom-gate top-contact transistor. The thin film transistor includes a flexible substrate 11, a gate electrode layer 12, a first gate insulating film 21, a second gate insulating film 22, a semiconductor layer 13, a source electrode layer 14, and a drain electrode layer 15. The first gate insulating film 21 and the second gate insulating film 22 form a gate insulating layer.

The flexible substrate 11 and the gate electrode layer 12 are arranged in a channel depth direction Z, which is the upward direction in Fig. 1. The source electrode layer 14 and the drain electrode layer 15 are arranged in a channel length direction X, which is right in Fig. 1. The channel width direction Y is orthogonal to the channel length direction X and the channel depth direction Z.

The upper surface of the flexible substrate 11 is a support surface 11S extending in the channel length direction X and the channel width direction Y. The support surface 11S includes a first part 11S1 and a second part 11S2 that are in contact with each other in the channel length direction X. The area of the first part 11S1 is smaller than that of the second part 11S2. The first part 11S1 is in contact with the lower surface of the gate electrode layer 12. The second part 11S2 is in contact with part of the lower surface of the first gate insulating film 21.

The first gate insulating film 21 is in contact with the upper surface of the gate electrode layer 12. The first gate insulating film 21 may either cover the entire support surface 11S or part of the support surface 11S.

The lower surface of the second gate insulating film 22 is in contact with the upper surface of the first gate insulating film 21. The second gate insulating film 22 may either cover the entire first gate insulating film 21 or part of the first gate insulating film 21. The second gate insulating film 22 covers the upper surface of the gate electrode layer 12 so that the first gate insulating film 21 is sandwiched between the second gate insulating film 22 and the gate electrode layer 12. Part of the first gate insulating film 21 is located between the gate electrode layer 12 and part of the second gate insulating film 22. The first gate insulating film 21 is disposed over the gate electrode layer 12. The second gate insulating film 22 is disposed over the first gate insulating film 21.

The lower surface of the semiconductor layer 13 is in contact with the upper surface of the second gate insulating film 22. The semiconductor layer 13 covers the upper surface of the gate electrode layer 12 so that the first gate insulating film 21 and the second gate insulating film 22 are sandwiched between the semiconductor layer 13 and the gate electrode layer 12. Part of the first gate insulating film 21 and part of the second gate insulating film 22 are located between the gate electrode layer 12 and the semiconductor layer 13. The semiconductor layer 13 is disposed over the second gate insulating film 22. In the channel length direction X, the length of the semiconductor layer 13 is greater than the length of the gate electrode layer 12.

Part of the lower surface of the source electrode layer 14 is in contact with the upper surface of the semiconductor layer 13. The other part of the lower surface of the source electrode layer 14 is in contact with the upper surface of the second gate insulating film 22. The source electrode layer 14 covers a first end of the semiconductor layer 13 so that it is connected to the first end of the semiconductor layer 13 in the direction opposite to the channel length direction X. The source electrode layer 14 is disposed over the first end of the semiconductor layer 13.

Part of the lower surface of the drain electrode layer 15 is in contact with the upper surface of the semiconductor layer 13. The other part of the lower surface of the drain electrode layer 15 is in contact with the upper surface of the second gate insulating film 22. The drain electrode layer 15 covers a second end of the semiconductor layer 13 so that it is connected to the second end of the semiconductor layer 13 in the channel length direction X. The drain electrode layer 15 is disposed over the second end of the semiconductor layer 13.

The source electrode layer 14 and the drain electrode layer 15 are separated from each other. A length L between the source electrode layer 14 and the drain electrode layer 15 in the channel length direction X is less than the length of the gate electrode layer 12. In this case, the region of the semiconductor layer 13 between the source electrode layer 14 and the drain electrode layer 15 is a channel region C. The length of the channel region C in the channel length direction X, that is, the length L between the source electrode layer 14 and the drain electrode layer 15 is the channel length. The length of the channel region C in the channel width direction Y is the channel width.

When the channel length of a thin film transistor varies depending on the position in the channel width direction Y, the average value of all the channel lengths is the channel length of that thin film transistor. When the length L is greater than the length of the gate electrode layer 12, the channel region C is the region of the semiconductor layer 13 that overlaps the gate electrode layer 12 in the channel depth direction Z.

As shown in Fig. 2, the thin film transistor is a bottom-gate bottom-contact transistor. In the following, the configuration different from that of the bottom-gate top-contact transistor will be mainly described.

The lower surface of the source electrode layer 14 is in contact with the upper surface of the second gate insulating film 22. The lower surface of the drain electrode layer 15 is in contact with the upper surface of the second gate insulating film 22.

Part of the lower surface of the semiconductor layer 13 is in contact with the second gate insulating film 22. Part of the lower surface of the semiconductor layer 13 forms the channel region C filling the gap between the source electrode layer 14 and the drain electrode layer 15 in the channel length direction X.

The first end of the semiconductor layer 13, which is the end of the lower surface thereof in the direction opposite to the channel length direction X, covers the upper surface of the source electrode layer 14 so that the first end is in contact with the upper surface of the source electrode layer 14. The second end of the semiconductor layer 13, which is the end of the lower surface thereof in the channel length direction X, covers the upper surface of the drain electrode layer 15 so that the second end is in contact with the upper surface of the drain electrode layer 15.

### [Flexible Substrate]

The flexible substrate 11 has an insulating upper surface. The flexible substrate 11 may be a transparent substrate or an opaque substrate. The flexible substrate 11 may be an insulating film, a metal foil having an insulating support surface 11S, an alloy foil having an insulating support surface 11S, or a flexible thin glass plate.

The material forming the flexible substrate 11 is at least one selected from the group consisting of organic polymer compounds, composite materials of organic and inorganic materials, metals, alloys, and inorganic polymer compounds.

The flexible substrate 11 may have a single-layer structure or a multilayer structure. When the flexible substrate 11 has a multilayer structure, the material of each of the layers forming the flexible substrate 11 is one selected from the group consisting of organic polymer compounds, composite materials, metals, alloys, and inorganic polymer compounds.

When the flexible substrate 11 has a multilayer structure, the flexible substrate 11 may include a base substrate and a release layer that can be peeled off from the base substrate. The release layer is peeled off from the base substrate together with the device structure. The release layer provided with the device structure may be attached to another flexible substrate. Examples of flexible substrates include paper with low heat resistance, cellophane substrates, cloth, recycled fibers, leather, nylon substrates, and polyurethane substrates. In this example, the release layer and the flexible substrate forms another flexible substrate 11.

The organic polymer compound is at least one selected from the group consisting of polymethyl methacrylate, polyacrylate, polycarbonate, polystyrene, polyethylene sulfide, polyether sulfone, polyolefin, polyethylene terephthalate, polyethylene naphthalate, cycloolefin polymer, polyether sulphene, triacetyl cellulose, polyvinyl fluoride film, ethylene-tetrafluoroethylene copolymers, polyimide, fluorine polymers, and cyclic polyolefin polymers.

The composite material is a glass fiber reinforced acrylic polymer or glass fiber reinforced polycarbonate. The metal is aluminum or copper. The alloy is an iron-chromium alloy, an iron-nickel alloy, or an iron-nickel-chromium alloy. The inorganic polymer compound is alkali-free glass including silicon oxide, boron oxide, and aluminum oxide, or alkali glass including silicon oxide, sodium oxide, and calcium oxide.

### [Electrode Layer]

The electrode layers 12, 14, and 15 may have a single-layer structure or a multilayer structure. When the electrode layers 12, 14, and 15 have a multilayer structure, each of them preferably includes a bottom layer for enhancing the adhesion with the layer below the electrode layer and a top layer for enhancing the adhesion with the layer above the electrode layer.

The material of each electrode layer 12, 14, 15 may be a metal, an alloy, or a conductive metal oxide. The materials of the electrode layers 12, 14, and 15 may be different from each other or the same.

The metal is at least one of transition metals, alkali metals, and alkaline earth metals. The transition metal is at least one selected from the group consisting of indium, aluminum, gold, silver, platinum, titanium, copper, nickel, and tungsten. The alkali metal is lithium or cesium. The alkaline earth metal is at least one of magnesium and calcium. The alloy is one selected from the group consisting of molybdenum-niobium (MoNb), iron-chromium, aluminum-lithium, magnesium-silver, aluminum-neodymium alloy, and aluminum-neodymium-zirconia alloy.

The metal oxide is one selected from the group consisting of indium oxide, tin oxide, zinc oxide, cadmium oxide, indium cadmium oxide, cadmium tin oxide, and zinc tin oxide. The metal oxide may contain impurities. The metal oxide containing impurities is indium oxide containing at least one impurity selected from the group consisting of tin, zinc, titanium, cerium, hafnium, zirconia, and molybdenum. The metal oxide containing impurities may be tin oxide containing antimony or fluorine. The metal oxide containing impurities may be zinc oxide containing at least one impurity selected from the group consisting of gallium, aluminum, and boron.

When the material forming the semiconductor layer 13 is a metal oxide, the electrode layers 14 and 15 may be made of the same constituent elements as the semiconductor layer 13 and have an impurity concentration sufficiently higher than that of the semiconductor layer 13.

In order to expand the range of materials that can be applied to the electrode layers 12, 14, and 15, the electrical resistivity of the electrode layers 12, 14, and 15 is preferably 5.0×10⁻⁵ Ω·cm or higher. In order to suppress the power consumption of the thin film transistor, the electrical resistivity of the electrode layers 12, 14, and 15 is preferably 1.0×10⁻² Ω·cm or lower.

In order to suppress the electric resistance of the electrode layers 12, 14, and 15, the thickness of each of the electrode layers 12, 14, and 15 is preferably 50 nm or greater. In order to improve the flatness of the layers constituting the thin film transistor, the thickness of each of the electrode layers 12, 14, and 15 is preferably 300 nm or less.

### [Semiconductor Layer]

The material of the semiconductor layer 13 may be an inorganic semiconductor or an organic semiconductor. The inorganic semiconductor may be an oxide semiconductor, amorphous silicon, or a compound semiconductor. The oxide semiconductor contains at least one of indium and zinc.

In order to increase the light transmittance and field-effect mobility (hereinafter also referred to as mobility) of the semiconductor layer 13, the semiconductor layer 13 is preferably an oxide semiconductor layer containing indium. The oxide semiconductor is more preferably an In-M-Zn oxide. An In-M-Zn oxide includes indium (In) and zinc (Zn), and also includes at least one metal element (M) selected from the group consisting of aluminum, titanium, gallium (Ga), germanium, yttrium, zirconium, lanthanum, cerium, hafnium, and tin.

In order to improve the uniformity of the thickness of the semiconductor layer 13, the thickness of the semiconductor layer 13 is preferably 5 nm or greater. In order to reduce the amount of the material used to form the semiconductor layer 13, the thickness of the semiconductor layer 13 is preferably 100 nm or less. In order to achieve both improved thickness uniformity and reduced amount of material used, the thickness of the semiconductor layer 13 is preferably 5 nm or greater and 100 nm or less. Further, in order to enhance the effectiveness of obtaining these effects, the thickness of the semiconductor layer 13 is more preferably 10 nm or greater and 50 nm or less.

In order to improve the mobility, the electrical resistivity of the semiconductor layer 13 is preferably 1.0×10⁴ Ω·cm or lower. In order to increase the current on/off ratio, which is the ratio of the on-current value to the off-current value, the electrical resistivity of the semiconductor layer 13 is preferably 1.0×10 -1 Ω·cm or higher. In order to improve both the mobility and the current on/off ratio, the electrical resistivity of the semiconductor layer 13 is preferably 1.0×10⁻¹ Ω·cm or higher and 1.0×10⁴ Ω·cm or lower. Further, in order to enhance the effectiveness of obtaining these effects, the electrical resistivity of the semiconductor layer 13 is more preferably 1.0×10⁰ Ω·cm or higher and 1.0×10³ Ω·cm or lower.

### [Insulating Film]

The material forming the first gate insulating film 21 is an organic polymer compound. The organic polymer compound is at least one selected from the group consisting of polyvinylphenol, polyimide, polyvinyl alcohol, acrylic polymers, epoxy polymers, fluoropolymers including amorphous fluoropolymers, melamine polymers, furan polymers, xylene polymers, polyamideimide polymers, and silicone polymers. In order to increase the heat resistance of the first gate insulating film 21, the organic polymer compound is preferably at least one selected from the group consisting of polyimide, acrylic polymers, and fluoropolymers.

The first gate insulating film 21 may be a single layer film or a multilayer film. When the first gate insulating film 21 is a multilayer film, the material of each of the layers constituting the first gate insulating film 21 is an organic polymer compound.

The relative permittivity ε_{A} of the first gate insulating film 21 is 2.0 or higher and 5.0 or lower. When reducing the thickness of the first gate insulating film 21 to increase the mobility, the relative permittivity of the first gate insulating film 21 is preferably 3.0 or higher and 4.0 or lower.

In order to suppress current leakage between the gate electrode layer 12 and the other electrode layers 14 and 15, the thickness of the first gate insulating film 21 is preferably 500 nm or greater. In order to reduce the gate voltage for driving the thin film transistor, the thickness of the first gate insulating film 21 is preferably 10 µm or less. In order to reduce the current leakage and the gate voltage, the thickness of the first gate insulating film 21 is preferably 500 nm or greater and 10 µm or less. Further, in order to improve the effectiveness of obtaining these effects, improve the uniformity of the thickness of the first gate insulating film 21, and improve the productivity of the first gate insulating film 21, the thickness of the first gate insulating film 21 is more preferably 1000 nm or greater and 5000 nm or less. The thickness of the first gate insulating film 21 is even more preferably 1000 nm or greater and 2500 nm or less.

In order to improve the withstand voltage of the gate insulating layer, the resistivity of the gate insulating layer is preferably 1×10¹¹ Ω·cm or higher. In order to reduce the thickness of the first gate insulating film 21, the resistivity of the gate insulating layer is more preferably 1×10¹³ Ω·cm or higher.

The material forming the second gate insulating film 22 is an inorganic silicon compound having no long-range order. The inorganic silicon compound is at least one selected from the group consisting of silicon oxide, silicon nitride, and silicon oxynitride. Elements constituting silicon nitride include oxygen, silicon, and hydrogen. Elements constituting silicon nitride include nitride, silicon, and hydrogen. Elements constituting silicon oxynitride include oxygen, nitride, silicon, and hydrogen.

The relative permittivity ε_{B} of the second gate insulating film 22 is greater than or equal to the relative permittivity ε_{A} of the first gate insulating film 21 and is 3.5 or greater and 10 or less. In order to obtain a continuous film of the inorganic silicon compound instead of scattered islands, the thickness of the second gate insulating film 22 is 2 nm or greater.

The second gate insulating film 22 may be a single layer film or a multilayer film. When the second gate insulating film 22 is a multilayer film, the material of each of the layers constituting the second gate insulating film 22 is an inorganic silicon compound.

Silicon oxide has hydrogen in at least one of the form of a silicon-hydrogen bond and the form of an oxygen-hydrogen bond. The ratio of the oxygen content in silicon oxide to the silicon content in silicon oxide is two (the stoichiometric ratio of silicon dioxide) or less.

Silicon nitride has hydrogen in at least one of the form of a silicon-hydrogen bond and the form of a nitride-hydrogen bond. The ratio of the nitride content in silicon nitride to the silicon content in silicon nitride is 4/3 (the stoichiometric ratio of trisilicon tetranitride) or less.

Silicon oxynitride has hydrogen in at least one of the form of a silicon-hydrogen bond, the form of an oxygen-hydrogen bond, and the form of a nitride-hydrogen bond. The silicon oxynitride may have a composition in which the nitrogen content is higher than the oxygen content, or the oxygen content is higher than the nitrogen content.

The hydrogen in the inorganic silicon compound forms defects in the lattice of the inorganic silicon compound that forms the short-range order, and alleviates fluctuation of the short-range order due to bending of the flexible substrate 11. The greater the hydrogen content, the more likely there are fewer silicon dangling bonds in the inorganic silicon compound. In addition, since the content of oxygen and nitrogen in the inorganic silicon compound tends to decrease, when the semiconductor layer 13 is an oxide semiconductor, it is easy to maintain a suitable amount of oxygen vacancies in the oxide semiconductor. On the other hand, if the hydrogen content is too large, hydrogen tends to dissociate from silicon in the second gate insulating film 22, and the threshold voltage may change due to the dissociated hydrogen diffusing.

Therefore, when the material forming the second gate insulating film 22 is at least one of silicon oxide, silicon nitride, and silicon oxynitride, the second gate insulating film 22 satisfies the following conditions 1 and 2 to increase the durability of the electrical characteristics against bending of the flexible substrate 11. Note that at% represents atomic percent.

(Condition 1) The hydrogen content is 2 at% or more and 15 at% or less.

(Condition 2) The thickness d_{B} is 30 nm or less.

Further, when the material forming the second gate insulating film 22 is silicon oxide, the second gate insulating film 22 satisfies the following conditions 3 and 4 to increase the durability of the electrical characteristics against bending of the flexible substrate 11.

(Condition 3) The hydrogen content is 2 at% or more and 14 at% or less.

(Condition 4) The thickness d_{B} is 40 nm or less.

Further, in order to increase the effectiveness of improving the durability of electrical characteristics, the hydrogen content of silicon oxide is preferably 6 at% or more and 10 at% or less, and the thickness of the second gate insulating film 22 is preferably 5 nm or greater and 25 nm or less.

When the material forming the second gate insulating film 22 is silicon nitride, the second gate insulating film 22 satisfies the following conditions 5 and 6 to increase the durability of electrical characteristics against bending of the flexible substrate 11.

(Condition 5) The hydrogen content is 5 at% or more and 18 at% or less.

(Condition 6) The thickness d_{B} is 30 nm or less.

Further, in order to improve the electrical characteristics of the thin film transistor, the gate insulating layer, which is a laminated structure of the first gate insulating film 21 and the second gate insulating film 22, preferably satisfies the following formula (1). The first gate insulating film 21 has a relative permittivity ε_{A} and a thickness d_{A}, and the second gate insulating film 22 has a relative permittivity ε_{B} and a thickness d_{B}.$0.001 \leq \left({ε}_{A}{/ d}_{A}\right) / \left({ε}_{B}{/ d}_{B}\right) < 0.015$ (1)

In order to increase the withstand voltage of the gate insulating layer, the dielectric property value K (= (ε_{A}/d_{A})/(ε_{B}/d_{B})) is preferably less than 0.015. In order to increase the mobility, the dielectric property value K is preferably 0.001 or greater.

### [Method of Manufacturing Thin Film Transistor]

A method of manufacturing a bottom-gate top-contact transistor includes a first step of forming the gate electrode layer 12 on the flexible substrate 11, a second step of laminating the first gate insulating film 21 on the gate electrode layer 12, and a third step of laminating the second gate insulating film 22 on the first gate insulating film 21. The method of manufacturing a bottom-gate top-contact transistor also includes a fourth step of laminating the semiconductor layer 13 on the second gate insulating film 22, and a fifth step of laminating the source electrode layer 14 and the drain electrode layer 15 on the semiconductor layer 13.

Note that, in a method of manufacturing a bottom-gate bottom-contact transistor, in the fourth step, the source electrode layer 14 and the drain electrode layer 15 are laminated on the second gate insulating film 22. In the fifth step, the semiconductor layer 13 is laminated on the source electrode layer 14, the drain electrode layer 15, and the second gate insulating film 22. The method used in the fourth step is the method used in the fifth step in the method of manufacturing a bottom-gate top-contact transistor. The method used in the fifth step is the method used in the fourth step in the method of manufacturing a bottom-gate top-contact transistor. Therefore, the method of manufacturing a bottom-gate top-contact transistor will be mainly described below, and redundant description of the method of manufacturing a bottom-gate bottom-contact transistor will be omitted.

In the first step, the gate electrode layer 12 may be formed with a film formation method using a mask that follows the shape of the gate electrode layer 12. Alternatively, the gate electrode layer 12 may be formed by forming an electrode film for forming the gate electrode layer 12 and then processing the electrode film into the shape of the gate electrode layer 12 by etching.

The film forming method used to form the gate electrode layer 12 is at least one selected from the group consisting of vacuum deposition, ion plating, sputtering, laser ablation, spin coating using conductive paste, dip coating, and slit die coating. Alternatively, the film forming method used to form the gate electrode layer 12 may be at least one selected from the group consisting of screen printing, relief printing, intaglio printing, planographic printing, and inkjet printing.

In the second step, the first gate insulating film 21 may be formed by a coating method using a mask that follows the shape of the first gate insulating film 21. Alternatively, the first gate insulating film 21 may be formed by forming a coating film for forming the first gate insulating film 21 and then processing the coating film into the shape of the first gate insulating film 21 by photolithography.

The coating method used to form the first gate insulating film 21 is at least one selected from the group consisting of spin coating, dip coating, slit die coating, screen printing, and inkjet printing, using a coating solution containing an organic polymer compound. In the coating method, the coating film is formed by baking a liquid film formed by the coating solution. When photolithography is used to form the first gate insulating film 21, the coating solution contains a photosensitive polymer.

In the third step, the second gate insulating film 22 may be formed by a coating method using a mask that follows the shape of the second gate insulating film 22. Alternatively, the second gate insulating film 22 may be formed by forming an insulating film for forming the second gate insulating film 22 and then processing the coating film into the shape of the second gate insulating film 22 by etching.

The film forming method used to form the second gate insulating film 22 is at least one selected from the group consisting of laser ablation, plasma CVD, optical CVD, thermal CVD, sputtering, and sol-gel. Alternatively, the film forming method used to form the second gate insulating film 22 may be at least one coating method selected from the group consisting of spin coating, dip coating, slit die coating, screen printing, and inkjet printing, using a coating solution containing a precursor of an inorganic polymer compound.

In the fourth step, the semiconductor layer 13 may be formed with a film formation method using a mask that follows the shape of the semiconductor layer 13. Alternatively, the semiconductor layer 13 may be formed by forming a semiconductor film for forming the semiconductor layer 13 and then processing the semiconductor film into the shape of the semiconductor layer 13 by etching.

The semiconductor layer 13 is formed by sputtering or CVD. Sputtering includes DC sputtering in which a DC voltage is applied to the flexible substrate 11, or RF sputtering in which radio waves are applied to the film forming space. The impurities may be introduced by ion implantation, ion doping, or plasma immersion-ion implantation.

In the fifth step, the source electrode layer 14 and the drain electrode layer 15 may be formed by a film formation method using a mask that follows the shape of the electrode layer. Alternatively, the source electrode layer 14 and the drain electrode layer 15 may be formed by forming electrode films for forming the electrode layers 14 and 15 and then processing the electrode films into the shape of the source electrode layer 14 and the drain electrode layer 15 by etching.

The film forming method used to form the source electrode layer 14 and the drain electrode layer 15 is at least one selected from the group consisting of vacuum deposition, ion plating, sputtering, laser ablation, spin coating using conductive paste, dip coating, and slit die coating. Alternatively, the film forming method used to form the gate electrode layer 12 may be at least one selected from the group consisting of screen printing, relief printing, intaglio printing, planographic printing, and inkjet printing.

### [Example 1]

First, a polyimide film was used as the flexible substrate 11, and a MoNb film with a thickness of 100 nm was used as the gate electrode layer 12. The gate electrode layer 12 was formed by placing a shadow mask on the upper surface of the flexible substrate 11 and using non-thermal sputtering with a MoNb sintered body as the target. The conditions for forming the MoNb film by non-thermal sputtering are shown below.

### <Conditions for MoNb Film Formation>

- Target composition ratio: Mo (at%):Nb (at%) = 9:1
- Sputtering gas: Argon
- Sputtering gas flow rate: 45 sccm
- Film formation pressure: 1.0 Pa
- Target power: 200 W (DC)

An acrylic polymer film with a thickness d_{A} of 1000 nm was used as the first gate insulating film 21, and a silicon oxide film with a thickness d_{B} of 2 nm was used as the second gate insulating film 22.

For the formation of the acrylic polymer film, first, a coating film was laminated on the upper surfaces of the flexible substrate 11 and the gate electrode layer 12 by spin coating using an acrylic polymer as the organic polymer compound. Then, the coating film was baked to obtain an acrylic polymer film.

To measure the relative permittivity ε_{A}, the first gate insulating film 21 of Example 1 was formed on a substrate. The measured relative permittivity ε_{A} was 3.5. The conditions for forming the acrylic polymer film by the spin coating method were as follows.

### <Conditions for Acrylic Polymer Film Formation>

- Substrate rotation speed: 730 rpm/30 sec
- Calcination temperature: 90°C
- Calcination time: 2 minutes
- Sintering temperature: 200°C
- Sintering time: 1 hour

In the formation of the silicon oxide film, parallel plate plasma CVD was used to laminate the silicon oxide film on the upper surface of the acrylic polymer film. To measure the relative permittivity ε_{B}, the silicon oxide film of Example 1 was formed on a substrate. The measured relative permittivity ε_{B} of the second insulating film 22 of Example 1 was 4.7. The conditions for forming the silicon oxide film by parallel plate plasma CVD were as follows.

### <Conditions for Silicon Oxide Film Formation>

- Substrate temperature: 200°C
- Reactant gas: Silane/nitrous oxide
- Reactant gas flow rate: 65 sccm (silane), 500 sccm (nitrous oxide)
- Film formation pressure: 200 Pa
- Radio wave power: 500 W
- Radio wave power frequency: 13.56 MHz

The dielectric property value K of the gate insulating layer of Example 1 was 0.00149.

To measure the hydrogen content rH, the silicon oxide film of Example 1 was formed on the substrate, and the hydrogen content rH (atomic concentration: at%) of the second gate insulating film 22 of Example 1 was measured by hydrogen forward scattering spectrometry (HFS). The hydrogen content rH in the second gate insulating film 22 of Example 1 was 9.7 at%. Using Rutherford Backscattering Spectrometry (RBS), the silicon content in the silicon oxide film of Example 1 was 31.2 at%, the oxygen content was 58.0 at%, and nitrogen and carbon were below the detection limit.

An InGaZnO film with a thickness of 35 nm was used as the semiconductor layer 13. The InGaZnO film was formed by placing a shadow mask on the upper surface of the second gate insulating film 22 and using non-thermal sputtering with an InGaZnO sintered body as the target. The conditions for forming the InGaZnO film by non-thermal sputtering were as follows.

### <Conditions for InGaZnO Film Formation>

- Target composition ratio: at% In:Ga:Zn:O = 1:1:1:4
- Sputtering gas: Argon/oxygen
- Sputtering gas flow rate: 50 sccm (argon), 0.2 sccm (oxygen)
- Film formation pressure: 1.0 Pa • Target power: 300 W
- Target frequency: 13.56 MHz

A MoNb film with a thickness of 100 nm was used as the source electrode layer 14. A MoNb film with a thickness of 100 nm was used as the drain electrode layer 15. The source electrode layer 14 and the drain electrode layer 15 were formed by placing a shadow mask on the upper surfaces of the second gate insulating film 22 and the semiconductor layer 13 and using non-thermal sputtering with a MoNb sintered body as the target. The conditions for forming the MoNb film by non-thermal sputtering are shown below.

### <Conditions for MoNb Film Formation>

- Target composition ratio: at% Mo:Nb = 9:1
- Sputtering gas: Argon
- Sputtering gas flow rate: 45 sccm
- Film formation pressure: 1.0 Pa
- Target power: 200 W (DC)

The flexible substrate 11, the gate electrode layer 12, the first gate insulating film 21, the second gate insulating film 22, the semiconductor layer 13, the source electrode layer 14, and the drain electrode layer 15 were annealed at 150°C to obtain the bottom-gate top-contact transistor of Example 1. The thin film transistor of Example 1 had a channel length of 200 µm and a channel width of 2000 µm.

### [Example 2]

A silicon oxide film having a thickness d_{B} of 5 nm was used as the second gate insulating film 22 to obtain a bottom-gate top-contact transistor of Example 2 having the same structure as that of Example 1 except for the second gate insulating film 22. In the formation of the second gate insulating film 22, among the film formation conditions of Example 1, the film formation time was changed, and the conditions other than the film formation time were the same as those of Example 1. The silicon oxide film of Example 2 was obtained under these conditions.

The hydrogen content rH in the second gate insulating film 22 of Example 2 was 9.7 at%. The relative permittivity ε_{B} of the second gate insulating film 22 of Example 2 was 4.7, and the dielectric property value K of the gate insulating layer of Example 2 was 0.00372. The thin film transistor of Example 2 had a channel length of 200 µm and a channel width of 2000 µm.

### [Example 3]

A silicon oxide film having a thickness d_{B} of 20 nm was used as the second gate insulating film 22 to obtain a bottom-gate top-contact transistor of Example 3 having the same structure as that of Example 1 except for the second gate insulating film 22. In the formation of the second gate insulating film 22, among the film formation conditions of Example 1, the film formation time was changed, and the conditions other than the film formation time were the same as those of Example 1. The silicon oxide film of Example 3 was obtained under these conditions.

The hydrogen content rH in the second gate insulating film 22 of Example 3 was 9.7 at%. The relative permittivity ε_{B} of the second gate insulating film 22 of Example 3 was 4.7, and the dielectric property value K of the gate insulating layer of Example 3 was 0.01489. The thin film transistor of Example 3 had a channel length of 200 µm and a channel width of 2000 µm.

### [Example 4]

A silicon nitride film having a thickness of 5 nm was used as the second gate insulating film 22 to obtain a bottom-gate top-contact transistor of Example 4 having the same structure as that of Example 1 except for the second gate insulating film 22. The silicon oxide film was formed on the upper surface of the acrylic polymer film using parallel plate plasma CVD. The conditions for forming the silicon nitride film by plasma CVD were as follows.

### <Conditions for Silicon Nitride Film Formation>

- Substrate temperature: 200°C
- Reactant gas: Silane/ammonia/hydrogen/nitrogen
- Reactant gas flow rate: 10 sccm (silane), 70 sccm (ammonia)
   3000 sccm (hydrogen), 2000 sccm (nitrogen)
- Film formation pressure: 300 Pa
- Radio wave power: 500 W
- Radio wave power frequency: 13.56 MHz

The hydrogen content rH in the second gate insulating film 22 of Example 4 was 14.1 at%. The relative permittivity ε_{B} of the second gate insulating film 22 of Example 4 was 7.8, and the dielectric property value K of the gate insulating layer of Example 4 was 0.00224. The thin film transistor of Example 4 had a channel length of 200 µm and a channel width of 2000 µm. Using Rutherford Backscattering Spectrometry (RBS), the silicon content in the silicon nitride film of Example 4 was 40.1 at%, the nitrogen content was 43.5 at%, the oxygen content was 1.9 at%, and carbon was below the detection limit.

### [Example 5]

A silicon nitride film having a thickness d_{B} of 15 nm was used as the second gate insulating film 22 to obtain a bottom-gate top-contact transistor of Example 5 having the same structure as that of Example 1 except for the second gate insulating film 22. In the formation of the second gate insulating film 22, the film formation time was changed, and the conditions other than the film formation time were the same as those of Example 4. The silicon nitride film was obtained under these conditions.

The hydrogen content rH in the second gate insulating film 22 of Example 5 was 14.1 at%. The relative permittivity ε_{B} of the second gate insulating film 22 of Example 5 was 7.8, and the dielectric property value K of the gate insulating layer of Example 5 was 0.01346. The thin film transistor of Example 5 had a channel length of 200 µm and a channel width of 2000 µm.

### [Example 6]

A silicon oxynitride film having a thickness d_{B} of 20 nm was used as the second gate insulating film 22 to obtain a bottom-gate top-contact transistor of Example 6 having the same structure as that of Example 1 except for the second gate insulating film 22. The silicon oxynitride film was formed on the upper surface of the acrylic polymer film using parallel plate plasma CVD. The conditions for forming the silicon oxynitride film by plasma CVD were as follows.

### <Conditions for Silicon Oxynitride Film Formation>

- Substrate temperature: 200°C
- Reactant gas: Silane/ammonia/hydrogen/nitrous oxide
- Reactant gas flow rate: 10 sccm (silane), 60 sccm (ammonia)
   3000 sccm (hydrogen), 1500 sccm (nitrogen)
- Film formation pressure: 300 Pa
- Radio wave power: 500 W
- Radio wave power frequency: 13.56 MHz

The hydrogen content rH in the second gate insulating film 22 of Example 6 was 14.1 at%. The relative permittivity ε_{B} of the second gate insulating film 22 of Example 6 was 6.1, and the dielectric property value K of the gate insulating layer of Example 6 was 0.01147. The thin film transistor of Example 6 had a channel length of 200 µm and a channel width of 2000 µm.

### [Example 7]

A silicon oxide film having a thickness d_{B} of 5 nm was used as the second gate insulating film 22 to obtain a bottom-gate top-contact transistor of Example 7 having the same structure as that of Example 1 except for the second gate insulating film 22. In the formation of the silicon oxide film, parallel plate plasma CVD was used to laminate the silicon oxide film on the upper surface of the acrylic polymer film. The conditions for forming the silicon oxide film by parallel plate plasma CVD were as follows.

### <Conditions for Silicon Oxide Film Formation>

- Substrate temperature: 200°C
- Reactant gas: Silane/nitrous oxide
- Reactant gas flow rate: 65 sccm (silane), 600 sccm (nitrous oxide)
- Film formation pressure: 200 Pa
- Radio wave power: 500 W
- Radio wave power frequency: 13.56 MHz

The hydrogen content rH in the second gate insulating film 22 of Example 7 was 3.0 at%. The relative permittivity ε_{B} of the second gate insulating film 22 of Example 7 was 4.2, and the dielectric property value K of the gate insulating layer of Example 7 was 0.00417. The thin film transistor of Example 7 had a channel length of 200 µm and a channel width of 2000 µm.

### [Example 8]

A silicon oxide film having a thickness d_{B} of 25 nm was used as the second gate insulating film 22 to obtain a bottom-gate top-contact transistor of Example 8 having the same structure as that of Example 1 except for the second gate insulating film 22. In the formation of the silicon oxide film, parallel plate plasma CVD was used to laminate the silicon oxide film on the upper surface of the acrylic polymer film. In the formation of the silicon oxide film, among the film formation conditions of Example 1, the film formation time was changed, and the conditions other than the film formation time were the same as those of Example 1. The silicon oxide film of Example 8 was obtained under these conditions.

The hydrogen content rH in the second gate insulating film 22 of Example 8 was 9.7 at%. The relative permittivity ε_{B} of the second gate insulating film 22 of Example 8 was 4.7, and the dielectric property value K of the gate insulating layer of Example 8 was 0.01861. The thin film transistor of Example 8 had a channel length of 200 µm and a channel width of 2000 µm.

### [Example 9]

An acrylic polymer film with a thickness d_{A} of 2500 nm was used as the first gate insulating film 21. A silicon oxide film having a thickness d_{B} of 3 nm was used as the second gate insulating film 22 to obtain a bottom-gate top-contact transistor of Example 9 having the same structure as that of Example 1 except for the first and second gate insulating films 21 and 22. In the formation of the acrylic film, among the film formation conditions of Example 8, the coating amount was changed, and the conditions other than the coating amount were the same as those of Example 1. The acrylic polymer film of Example 9 was obtained under these conditions. In the formation of the silicon oxide film, among the film formation conditions of Example 1, the film formation time was changed, and the conditions other than the film formation time were the same as those of Example 1. The silicon oxide film of Example 9 was obtained under these conditions.

The hydrogen content rH in the second gate insulating film 22 of Example 9 was 9.7 at%. The relative permittivity ε_{B} of the second gate insulating film 22 of Example 9 was 4.7, and the dielectric property value K of the gate insulating layer of Example 9 was 0.00089. The thin film transistor of Example 9 had a channel length of 200 µm and a channel width of 2000 µm.

### [Example 10]

An acrylic polymer film with a thickness d_{A} of 2000 nm as the first gate insulating film 21, and a silicon nitride film having a thickness d_{B} of 4 nm as the second gate insulating film 22 were used to obtain a bottom-gate top-contact transistor of Example 10 having the same structure as that of Example 4 except for the first and second gate insulating films 21 and 22. In the formation of the acrylic film, among the film formation conditions of Example 4, the coating amount was changed, and the conditions other than the coating amount were the same as those of Example 4. The acrylic polymer film of Example 10 was obtained under these conditions. In the formation of the silicon nitride film, among the film formation conditions of Example 4, the film formation time was changed, and the conditions other than the film formation time were the same as those of Example 4. The silicon nitride film of Example 10 was obtained under these conditions.

The hydrogen content rH in the second gate insulating film 22 of Example 10 was 14.1 at%. The relative permittivity ε_{B} of the second gate insulating film 22 of Example 10 was 7.8, and the dielectric property value K of the gate insulating layer of Example 10 was 0.00090. The thin film transistor of Example 10 had a channel length of 200 µm and a channel width of 2000 µm.

### [Example 11]

An acrylic polymer film with a thickness d_{A} of 600 nm as the first gate insulating film 21, and a silicon nitride film having a thickness d_{B} of 7 nm as the second gate insulating film 22 were used to obtain a bottom-gate top-contact transistor of Example 11 having the same structure as that of Example 1 except for the first and second gate insulating films 21 and 22. In the formation of the acrylic film, among the film formation conditions of Example 1, the coating amount was changed, and the conditions other than the coating amount were the same as those of Example 1. The acrylic polymer film of Example 11 was obtained under these conditions. In the formation of the silicon oxide film, among the film formation conditions of Example 1, the film formation time was changed, and the conditions other than the film formation time were the same as those of Example 1. The silicon oxide film of Example 11 was obtained under these conditions.

The hydrogen content rH in the second gate insulating film 22 of Example 11 was 9.7 at%. The relative permittivity ε_{B} of the second gate insulating film 22 of Example 11 was 4.7, and the dielectric property value K of the gate insulating layer of Example 11 was 0.00869. The thin film transistor of Example 11 had a channel length of 200 µm and a channel width of 2000 µm.

### [Example 12]

An acrylic polymer film with a thickness d_{A} of 400 nm as the first gate insulating film 21, and a silicon nitride film having a thickness d_{B} of 7 nm as the second gate insulating film 22 were used to obtain a bottom-gate top-contact transistor of Example 12 having the same structure as that of Example 1 except for the first and second gate insulating films 21 and 22. In the formation of the acrylic film, among the film formation conditions of Example 1, the coating amount was changed, and the conditions other than the coating amount were the same as those of Example 1. The acrylic polymer film of Example 12 was obtained under these conditions. In the formation of the silicon oxide film, among the film formation conditions of Example 1, the film formation time was changed, and the conditions other than the film formation time were the same as those of Example 1. The silicon oxide film of Example 12 was obtained under these conditions.

The hydrogen content rH in the second gate insulating film 22 of Example 12 was 9.7 at%. The relative permittivity ε_{B} of the second gate insulating film 22 of Example 12 was 4.7, and the dielectric property value K of the gate insulating layer of Example 12 was 0.01303. The thin film transistor of Example 12 had a channel length of 200 µm and a channel width of 2000 µm.

### [Example 13]

An acrylic polymer film with a thickness d_{A} of 300 nm as the first gate insulating film 21, and a silicon nitride film having a thickness d_{B} of 4 nm as the second gate insulating film 22 were used to obtain a bottom-gate top-contact transistor of Example 13 having the same structure as that of Example 4 except for the first and second gate insulating films 21 and 22. In the formation of the acrylic film, among the film formation conditions of Example 1, the coating amount was changed, and the conditions other than the coating amount were the same as those of Example 1. The acrylic polymer film of Example 13 was obtained under these conditions. In the formation of the silicon nitride film, among the film formation conditions of Example 4, the film formation time was changed, and the conditions other than the film formation time were the same as those of Example 4. The silicon nitride film of Example 13 was obtained under these conditions.

The hydrogen content rH in the second gate insulating film 22 of Example 13 was 14.1 at%. The relative permittivity ε_{B} of the second gate insulating film 22 of Example 13 was 7.8, and the dielectric property value K of the gate insulating layer of Example 13 was 0.00598. The thin film transistor of Example 13 had a channel length of 200 µm and a channel width of 2000 µm.

### [Example 14]

An acrylic polymer film with a thickness d_{A} of 600 nm as the first gate insulating film 21, and a silicon nitride film having a thickness d_{B} of 4 nm as the second gate insulating film 22 were used to obtain a bottom-gate top-contact transistor of Example 14 having the same structure as that of Example 4 except for the first and second gate insulating films 21 and 22. In the formation of the acrylic film, among the film formation conditions of Example 4, the coating amount was changed, and the conditions other than the coating amount were the same as those of Example 4. The acrylic polymer film of Example 14 was obtained under these conditions. In the formation of the silicon nitride film, among the film formation conditions of Example 4, the film formation time was changed, and the conditions other than the film formation time were the same as those of Example 4. The silicon nitride film of Example 14 was obtained under these conditions.

The hydrogen content rH in the second gate insulating film 22 of Example 14 was 14.1 at%. The relative permittivity ε_{B} of the second gate insulating film 22 of Example 14 was 7.8, and the dielectric property value K of the gate insulating layer of Example 14 was 0.00298. The thin film transistor of Example 14 had a channel length of 200 µm and a channel width of 2000 µm.

### [Example 15]

A silicon oxide film having a thickness d_{B} of 25 nm was used as the second gate insulating film 22 to obtain a bottom-gate top-contact transistor of Example 15 having the same structure as that of Example 1 except for the second gate insulating film 22. In the formation of the silicon oxide film, parallel plate plasma CVD was used to laminate the silicon oxide film on the upper surface of the acrylic polymer film. The conditions for forming the silicon oxide film by parallel plate plasma CVD were as follows.

### <Conditions for Silicon Oxide Film Formation>

- Substrate temperature: 200°C
- Reactant gas: Silane/nitrous oxide
- Reactant gas flow rate: 65 sccm (silane), 400 sccm (nitrous oxide)
- Film formation pressure: 200 Pa
- Radio wave power: 500 W
- Radio wave power frequency: 13.56 MHz

The hydrogen content rH in the second gate insulating film 22 of Example 13 was 12.1 at%. The relative permittivity ε_{B} of the second gate insulating film 22 of Example 13 was 4.7, and the dielectric property value K of the gate insulating layer of Example 15 was 0.01861. The thin film transistor of Example 15 had a channel length of 200 µm and a channel width of 2000 µm.

### [Example 16]

A silicon nitride film having a thickness d_{B} of 25 nm was used as the second gate insulating film 22 to obtain a bottom-gate top-contact transistor of Example 16 having the same structure as that of Example 4 except for the second gate insulating film 22. The silicon oxide film was formed on the upper surface of the acrylic polymer film using parallel plate plasma CVD. The conditions for forming the silicon nitride film by plasma CVD were as follows.

### <Conditions for Silicon Nitride Film Formation>

- Substrate temperature: 200°C
- Reactant gas: Silane/ammonia/hydrogen/nitrogen
- Reactant gas flow rate: 10 sccm (silane), 70 sccm (ammonia)
   2500 sccm (hydrogen), 2000 sccm (nitrogen)
- Film formation pressure: 300 Pa
- Radio wave power: 500 W
- Radio wave power frequency: 13.56 MHz

The hydrogen content rH in the second gate insulating film 22 of Example 16 was 6.9 at%. The relative permittivity ε_{B} of the second gate insulating film 22 of Example 16 was 7.8, and the dielectric property value K of the gate insulating layer of Example 16 was 0.01122. The thin film transistor of Example 16 had a channel length of 200 µm and a channel width of 2000 µm.

### [Comparative Example 1]

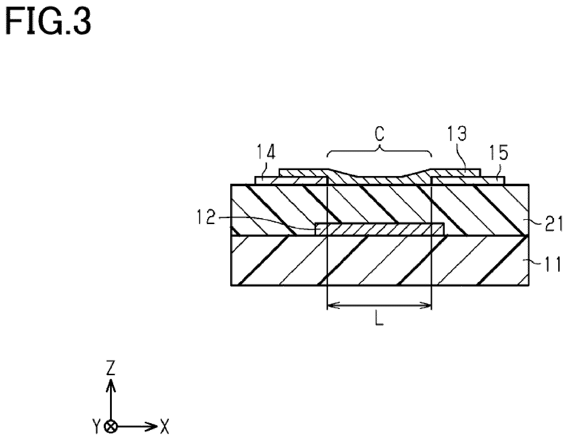

As shown in Fig. 3, the thin film transistor of Comparative Example 1 has a multilayer structure in which the second gate insulating film 22 is missing from the bottom-gate bottom-contact transistor described with reference to Fig. 2. That is, the thin film transistor of Comparative Example 1 has the source electrode layer 14 and the drain electrode layer 15 on the upper surface of the first gate insulating film 21. Further, in the thin film transistor of Comparative Example 1, the semiconductor layer 13 is provided over the upper surface of the source electrode layer 14, the upper surface of the drain electrode layer 15, and the upper surface of the first gate insulating film 21 so as to connect the source electrode layer 14 and the drain electrode layer 15.

As in the formation of the thin film transistor of Example 1, a polyimide film was used as the flexible substrate 11, a MoNb film having a thickness of 100 nm was used as the gate electrode layer 12, and an acrylic polymer film having a thickness of 1000 nm was used as the first gate insulating film 21 to form the thin film transistor of Comparative Example 1. The conditions for forming the MoNb film and the conditions for forming the acrylic polymer film were the same as in Example 1.

In the formation of the thin film transistor of Comparative Example 1, a shadow mask was placed on the upper surface of the first gate insulating film 21 to form a MoNb film having a thickness of 100 nm as the source electrode layer 14 and a MoNb film having a thickness of 100 nm as the drain electrode layer 15. As for the MoNb film formation conditions, non-thermal sputtering was performed in the same manner as in Example 1. Then, an InGaZnO film was formed as the semiconductor layer 13 on the upper surface of the first gate insulating film 21 so as to connect the source electrode layer 14 and the drain electrode layer 15. As for the InGaZnO film formation conditions, non-thermal sputtering was performed in the same manner as in Example 1. Then, annealing was performed at 150°C as in Example 1 to obtain the thin film transistor of Comparative Example 1. The thin film transistor of Comparative Example 1 had a channel length of 200 µm and a channel width of 2000 µm.

### [Comparative Example 2]

A silicon oxide film having a thickness d_{B} of 50 nm was used as the second gate insulating film 22 to obtain a bottom-gate top-contact transistor of Comparative Example 2 having the same structure as that of Example 1 except for the second gate insulating film 22. In the formation of the second gate insulating film 22, among the film formation conditions of Example 1, the film formation time was changed, and the conditions other than the film formation time were the same as those of Example 1. The silicon oxide film of Comparative Example 2 was obtained under these conditions.

The hydrogen content rH in the second gate insulating film 22 of Comparative Example 2 was 9.7 at%. The relative permittivity ε_{B} of the second gate insulating film 22 of Comparative Example 2 was 4.7, and the dielectric property value K of the gate insulating layer of Comparative Example 2 was 0.03723. The thin film transistor of Comparative Example 2 had a channel length of 200 µm and a channel width of 2000 µm.

### [Comparative Example 3]

A silicon nitride film having a thickness d_{B} of 35 nm was used as the second gate insulating film 22 to obtain a bottom-gate top-contact transistor of Comparative Example 3 having the same structure as that of Example 4 except for the second gate insulating film 22. In the formation of the second gate insulating film 22, among the film formation conditions of Example 4, the film formation time was changed, and the conditions other than the film formation time were the same as those of Example 4. The silicon nitride film of Comparative Example 3 was obtained under these conditions.

The hydrogen content rH in the second gate insulating film 22 of Comparative Example 3 was 14.1 at%. The relative permittivity ε_{B} of the second gate insulating film 22 of Comparative Example 3 was 7.8, and the dielectric property value K of the gate insulating layer of Comparative Example 4 was 0.01571. The thin film transistor of Comparative Example 4 had a channel length of 200 µm and a channel width of 2000 µm.

### [Comparative Example 4]

A silicon oxide film having a thickness d_{B} of 5 nm was used as the second gate insulating film 22 to obtain a bottom-gate top-contact transistor of Comparative Example 4 having the same structure as that of Example 1 except for the second gate insulating film 22. In the formation of the silicon oxide film, parallel plate plasma CVD was used to laminate the silicon oxide film on the upper surface of the acrylic polymer film. The conditions for forming the silicon oxide film by parallel plate plasma CVD were as follows.

### <Conditions for Silicon Oxide Film Formation>

- Substrate temperature: 200°C
- Reactant gas: Silane/nitrous oxide
- Reactant gas flow rate: 65 sccm (silane), 700 sccm (nitrous oxide)
- Film formation pressure: 200 Pa
- Radio wave power: 500 W
- Radio wave power frequency: 13.56 MHz

The hydrogen content rH in the second gate insulating film 22 of Comparative Example 4 was 1.0 at%. The relative permittivity ε_{B} of the second gate insulating film 22 of Comparative Example 4 was 3.9, and the dielectric property value K of the gate insulating layer of Comparative Example 4 was 0.00449. The thin film transistor of Comparative Example 4 had a channel length of 200 µm and a channel width of 2000 µm.

### [Comparative Example 5]

A silicon nitride film having a thickness of 10 nm was used as the second gate insulating film 22 to obtain a bottom-gate top-contact transistor of Comparative Example 5 having the same structure as that of Example 4 except for the second gate insulating film 22. The silicon oxide film was formed on the upper surface of the acrylic polymer film using parallel plate plasma CVD. The conditions for forming the silicon nitride film by plasma CVD were as follows.

### <Conditions for Silicon Nitride Film Formation>

- Substrate temperature: 200°C
- Reactant gas: Silane/ammonia/hydrogen/nitrogen
- Reactant gas flow rate: 10 sccm (silane), 70 sccm (ammonia)
   2000 sccm (hydrogen), 2000 sccm (nitrogen)
- Film formation pressure: 300 Pa
- Radio wave power: 500 W
- Radio wave power frequency: 13.56 MHz

The hydrogen content rH in the second gate insulating film 22 of Comparative Example 5 was 1.2 at%. The relative permittivity ε_{B} of the second gate insulating film 22 of Comparative Example 5 was 6.8, and the dielectric property value K of the gate insulating layer of Comparative Example 5 was 0.00515. The thin film transistor of Comparative Example 5 had a channel length of 200 µm and a channel width of 2000 µm.

### [Comparative Example 6]

A silicon oxide film having a thickness d_{B} of 25 nm was used as the second gate insulating film 22 to obtain a bottom-gate top-contact transistor of Comparative Example 6 having the same structure as that of Example 1 except for the second gate insulating film 22. In the formation of the silicon oxide film, parallel plate plasma CVD was used to laminate the silicon oxide film on the upper surface of the acrylic polymer film. The conditions for forming the silicon oxide film by parallel plate plasma CVD were as follows.

### <Conditions for Silicon Oxide Film Formation>

- Substrate temperature: 200°C
- Reactant gas: Silane/nitrous oxide
- Reactant gas flow rate: 65 sccm (silane), 800 sccm (nitrous oxide)
- Film formation pressure: 200 Pa
- Radio wave power: 500 W
- Radio wave power frequency: 13.56 MHz

The hydrogen content rH in the second gate insulating film 22 of Comparative Example 6 was below 1.0 at%. The relative permittivity ε_{B} of the second gate insulating film 22 of Comparative Example 6 was 3.9, and the dielectric property value K of the gate insulating layer of Comparative Example 6 was 0.02244. The thin film transistor of Comparative Example 6 had a channel length of 200 µm and a channel width of 2000 µm.

### [Comparative Example 7]

A silicon oxide film having a thickness d_{B} of 15 nm was used as the second gate insulating film 22 to obtain a bottom-gate top-contact transistor of Comparative Example 7 having the same structure as that of Example 1 except for the second gate insulating film 22. In the formation of the silicon oxide film, parallel plate plasma CVD was used to laminate the silicon oxide film on the upper surface of the acrylic polymer film. The conditions for forming the silicon oxide film by parallel plate plasma CVD were as follows.

### <Conditions for Silicon Oxide Film Formation>

- Substrate temperature: 200°C
- Reactant gas: Silane/nitrous oxide
- Reactant gas flow rate: 65 sccm (silane), 300 sccm (nitrous oxide)
- Film formation pressure: 200 Pa
- Radio wave power: 500 W
- Radio wave power frequency: 13.56 MHz

The hydrogen content rH in the second gate insulating film 22 of Comparative Example 7 was 16.2 at%. The relative permittivity ε_{B} of the second gate insulating film 22 of Comparative Example 7 was 5.1, and the dielectric property value K of the gate insulating layer of Comparative Example 7 was 0.01029. The thin film transistor of Comparative Example 7 had a channel length of 200 µm and a channel width of 2000 µm.

### [Comparative Example 8]

A silicon nitride film having a thickness of 15 nm was used as the second gate insulating film 22 to obtain a bottom-gate top-contact transistor of Comparative Example 8 having the same structure as that of Example 4 except for the second gate insulating film 22. The silicon oxide film was formed on the upper surface of the acrylic polymer film using parallel plate plasma CVD. The conditions for forming the silicon nitride film by plasma CVD were as follows.

### <Conditions for Silicon Nitride Film Formation>

- Substrate temperature: 200°C
- Reactant gas: Silane/ammonia/hydrogen/nitrogen
- Reactant gas flow rate: 10 sccm (silane), 70 sccm (ammonia)
   5000 sccm (hydrogen), 2000 sccm (nitrogen)
- Film formation pressure: 300 Pa
- Radio wave power: 500 W
- Radio wave power frequency: 13.56 MHz

The hydrogen content rH in the second gate insulating film 22 of Comparative Example 8 was 21.7 at%. The relative permittivity ε_{B} of the second gate insulating film 22 of Comparative Example 8 was 8.1, and the dielectric property value K of the gate insulating layer of Comparative Example 8 was 0.00648. The thin film transistor of Comparative Example 8 had a channel length of 200 µm and a channel width of 2000 µm.

### [Evaluation]

The transfer characteristics of the thin film transistors of Examples 1 to 16 and Comparative Examples 1 to 8 were measured using a semiconductor parameter analyzer (B 1500A, manufactured by Agilent Technologies, Inc.). Based on the transfer characteristics, the mobility, the variation ΔVth in the threshold voltage before and after a load test, and the rate of decrease in mobility before and after a bending test were calculated.

The measurement of the threshold voltage and the calculation of the mobility were carried out by first setting the voltage of the source electrode layer 14 to 0 V and the source-drain voltage Vds, which is the voltage between the source electrode layer 14 and the drain electrode layer 15, to 10 V to obtain the transfer characteristics, which is the relationship between the gate voltage Vgs and the drain current Id. The gate voltage Vgs is the voltage between the source electrode layer 14 and the gate electrode layer 12. The drain current Id is the current flowing through the drain electrode layer 15. The gate voltage Vgs was changed by changing the voltage of the gate electrode layer 12 from -20 V to +20 V. The gate voltage Vgs when the drain current Id is 1 mA was measured as the threshold voltage.

After that, using the transfer characteristics of the gate voltage Vgs and the drain current Id, the mutual conductance Gm (A/V), which is the change in the drain current Id with respect to the change in the gate voltage Vgs, was calculated. Then, the relative permittivity ε_{A} and thickness d_{A} of the first gate insulating film 21, the relative permittivity ε_{B} and thickness d_{B} of the second gate insulating film 22, the channel length, channel width, and source-drain voltage Vds were applied to the relational expression between the mutual conductance Gm and the source-drain voltage Vds in the linear region to calculate the mobility. The relational expression between the mutual conductance Gm and the source-drain voltage Vds assumes that the product of the source-drain voltage Vds, the capacitance of the gate insulating layer, and the mobility is proportional to the mutual conductance Gm. The mutual conductance Gm is represented by d(Id)/d(Vg).

In the load test (Negative Bias Temperature Stress, NBTS) used to measure the variation ΔVth in the threshold voltage, the voltage of the gate electrode layer 12 was set to -20 V, the source-drain voltage Vds was set to 0 V, the stress temperature was 60°C, and the stress application time was 1 hour. That is, the source electrode layer 14 and the drain electrode layer 15 of the thin film transistor were set to the same potential, and a potential lower than that of the source electrode layer 14 and the drain electrode layer 15 was applied to the gate electrode layer 12 for a certain period of time. Then, the threshold voltage after the load test was subtracted from the threshold voltage before the load test, and the subtracted value was measured as the variation ΔVth in the threshold voltage.

In the bending test used to measure the rate of decrease in mobility, the flexible substrate 11 was bent so that the radius of curvature became 1 mm, and then returned to its original state. This bending of the flexible substrate 11 was repeated 100,000 times. Then, the ratio of the difference value between the mobility before the bending test and the mobility after the bending test to the mobility before the bending test was calculated as the rate of decrease in mobility.

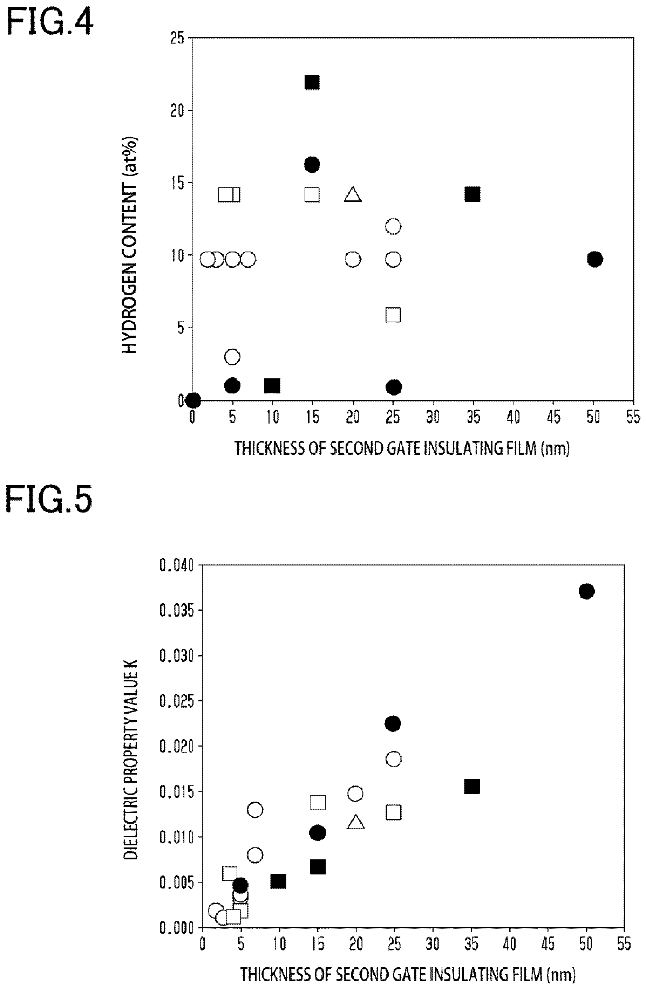

Fig. 4 shows the rate of decrease in mobility with respect to the thickness d_{B} and the hydrogen content rH of the second gate insulating film 22 for Examples 1 to 16 and Comparative Examples 1 to 8. The white circles in Fig. 4 indicate that the second gate insulating film 22 is a silicon oxide film and the rate of decrease in mobility is less than 20%. The black circles in Fig. 4 indicate that the second gate insulating film 22 is a silicon oxide film and the rate of decrease in mobility is greater than or equal to 20%. The white squares in Fig. 4 indicate that the second gate insulating film 22 is a silicon nitride film and the rate of decrease in mobility is less than 20%. The black squares in Fig. 4 indicate that the second gate insulating film 22 is a silicon nitride film and the rate of decrease in mobility is greater than or equal to 20%. The white triangles in Fig. 4 indicate that the second gate insulating film 22 is a silicon oxynitride film and the rate of decrease in mobility is less than or equal to 19%.

Fig. 5 shows the rate of decrease in mobility with respect to the thickness d_{B} and the dielectric property value K of the second gate insulating film 22 for Examples 1 to 16 and Comparative Examples 1 to 8. The white circles in Fig. 5 indicate that the second gate insulating film 22 is a silicon oxide film and the rate of decrease in mobility is less than 20%. The black circles in Fig. 5 indicate that the second gate insulating film 22 is a silicon oxide film and the rate of decrease in mobility is greater than or equal to 20%. The white squares in Fig. 5 indicate that the second gate insulating film 22 is a silicon nitride film and the rate of decrease in mobility is less than 20%. The black squares in Fig. 5 indicate that the second gate insulating film 22 is a silicon nitride film and the rate of decrease in mobility is greater than or equal to 20%. The white triangles in Fig. 5 indicate that the second gate insulating film 22 is a silicon oxynitride film and the rate of decrease in mobility is less than or equal to 19%.

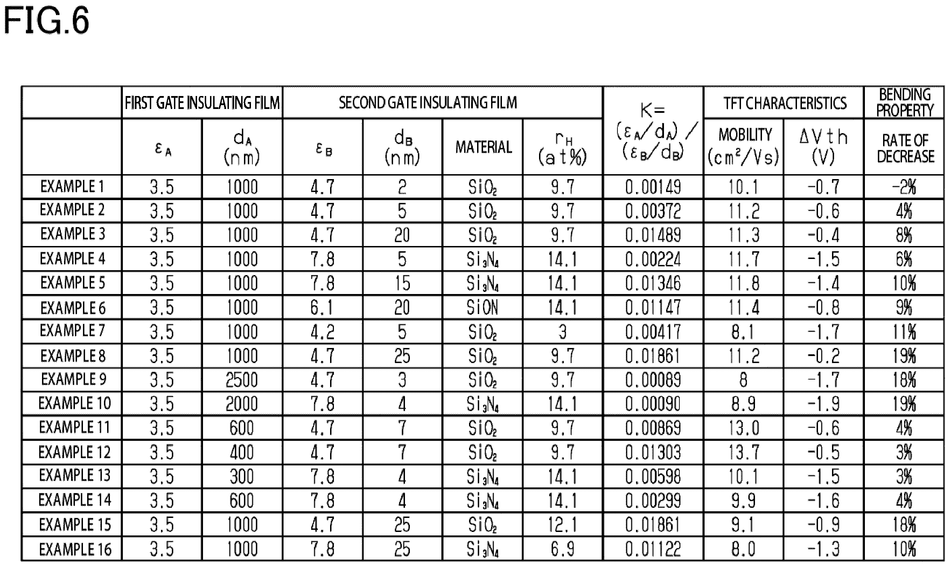

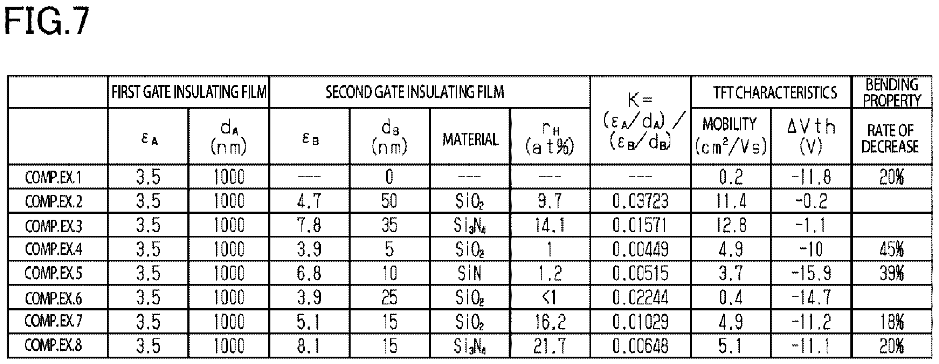

Figs. 6 and 7 show the relative permittivity ε_{A} and thickness d_{A} of the first gate insulating film 21, the relative permittivity ε_{B}, material, thickness d_{B}, and hydrogen content r_{H} of the second gate insulating film 22, and the dielectric property value K, mobility, variation in threshold voltage ΔVth, and rate of decrease in mobility for Examples 1 to 16 and Comparative Examples 1 to 8.

As shown in Fig. 6, the mobilities of Examples 1 to 16 were as high as 8.0 cm²/V or higher. On the other hand, the mobilities of Comparative Examples 1 and 4 to 8 were as low as 5.1 cm²/V or lower.

The variation ΔVth in threshold voltage of Examples 1 to 16 was as small as -1.9 V or higher and -0.2 V or lower. On the other hand, the variation ΔVth in threshold voltage of Comparative Examples 1 and 4 to 8 was as large as -10.0 V or lower.

The rate of decrease in mobility of Examples 1 to 16 was as low as 19% or lower. On the other hand, the rates of decrease in mobility of Comparative Examples 1, 4, 5, and 8 were as high as 20% or higher.

Similarly to the mobilities of Examples 1 to 16, the thin film transistors of Comparative Examples 2 and 3 showed high values that are 11.4 cm²/V or higher, and the variation ΔVth in threshold voltage was as small as -1.1 V or higher and -0.2 or lower. However, cracking or peeling was observed after the bending test.

First, from a comparison between Examples 1 to 16 and Comparative Example 1, it was found that the presence of the second gate insulating film 22 suppresses the variation ΔVth in the threshold voltage. On the other hand, from a comparison between Examples 1 to 16 and Comparative Examples 4 to 8, it was found that the hydrogen content rH of the second gate insulating film 22 is important for maintaining high mobility and suppressing the variation ΔVth in the threshold voltage, and that a suitable range exists for this.

For example, from the relationships of the variation ΔVth in the threshold voltage and the rate of decrease in mobility with the hydrogen content rH for Examples 3, 6 and 15 and Comparative Examples 4 and 7, it was found that, for inorganic silicon compounds containing oxygen, the variation ΔVth in threshold voltage can be suppressed and the rate of decrease in mobility can be suppressed (for example, to less than 20%) when the hydrogen content rH is 2 at% or higher. It was also found that the variation ΔVth in threshold voltage can be suppressed and high mobility can be obtained when the hydrogen content rH is 15 at% or lower. In particular, it was found that, when the second gate insulating film 22 is a silicon oxide film, if the hydrogen content rate rH is 14 at% (the intermediate value between the values of Example 15 and Comparative Example 7) or lower, the effectiveness of the effect of providing only a small variation ΔVth, high mobility, and low rate of decrease thereof can be enhanced.

For example, from the relationships of the variation ΔVth in the threshold voltage and the rate of decrease in mobility with the hydrogen content rH for Examples 4, 5, 6, and 16 and Comparative Examples 5 and 8, it was similarly found that, for inorganic silicon compounds containing nitrogen, the variation ΔVth in threshold voltage can be suppressed and the rate of decrease in mobility can be suppressed (for example, to less than 20%) when the hydrogen content rH is 2 at% or higher. It was also found that the variation ΔVth in threshold voltage can be suppressed and high mobility can be obtained when the hydrogen content rH is 15 at% or lower. In particular, it was found that, when the second gate insulating film 22 is a silicon nitride film, if the hydrogen content rate rH is 18 at% (the intermediate value between the values of Example 4 and Comparative Example 8) or lower, the effectiveness of the effect of providing only a small variation ΔVth, high mobility, and low rate of decrease thereof can be enhanced.

Next, from the relationship between the thickness d_{B} and the rate of decrease in mobility showed by Examples 1 to 3, 6, and 8 and Comparative Example 2, it was found that, the smaller the thickness d_{B} of the inorganic silicon compound containing oxygen, the lower the rate of decrease in mobility. The relationship between the thickness d_{B} and the rate of decrease in mobility showed by Examples 4 to 6 and Comparative Example 3 also showed that, the smaller the thickness d_{B} of the inorganic silicon compound containing nitride, the lower the rate of decrease in mobility.

Accordingly, it was found that a mobility as high as 8.0 cm²/V or higher can be obtained when the hydrogen content of an inorganic silicon compound satisfies Condition 1 (from the comparison between the Examples and Comparative Examples 4 to 8) and the thickness d_{B} satisfies Condition 2 (from the comparison between the Examples and Comparative Examples 1 to 3). It was also found that the decrease in mobility due to bending of the flexible substrate 11 can be suppressed. Note that the mobility durability against bending of the flexible substrate 11 can be obtained at a level that satisfies Conditions 1 and 2 with the dielectric property value K satisfying formula (1).

In particular, it was found that, when the second gate insulating film 22 is a silicon oxide film, the effectiveness of the effect of suppressing the decrease in mobility can be enhanced if the hydrogen content of the silicon oxide film satisfies Condition 3 (from the comparison between Examples 2 and 3 and Comparative Examples 6 and 7), and the thickness d_{B} satisfies Condition 4 (from the comparison between Examples 1 and 8 and Comparative Examples 1 and 2). That is, based on the intermediate thickness d_{B} value between the values of Example 8 and Comparative Example 2, it was found that the effect of suppressing the decrease in mobility can be enhanced by satisfying Condition 4.

In particular, it was found that, when the second gate insulating film 22 is a silicon nitride film, the effectiveness of the effect of suppressing the decrease in mobility can be enhanced if the hydrogen content of the silicon nitride film satisfies Condition 5 (from the comparison between Examples 4 and 5 and Comparative Examples 5 and 8), and the thickness d_{B} satisfies Condition 6 (from the comparison between Examples 5 and 10 and Comparative Examples 1 and 3). That is, based on the intermediate thickness d_{B} value between the values of Example 5 and Comparative Example 3, it was found that the effect of suppressing the decrease in mobility can be enhanced by satisfying Condition 6.

Further, it was found that when the structure includes the second gate insulating film 22 of Example 2, 3, or 8, a mobility that is higher than those of Examples 1, 7, and 9 can be obtained. Therefore, when a silicon oxide film has a hydrogen content of 6 at% or higher and 10 at% or lower, and a thickness d_{B} of 5 nm or greater and 25 nm or less, the mobility can be increased.

Further, it was found that when the structure includes the second gate insulating film 22 of Example 2 or 3, a mobility that is higher than those of Examples 1, 7, and 9 can be obtained, and also a rate of decrease in mobility as low as 8% or lower can be obtained. Therefore, when a silicon oxide film has a hydrogen content of 6 at% or higher and 10 at% or lower, and a thickness d_{B} of 5 nm or greater and 20 nm or less, a higher mobility after the bending test can be obtained.

A comparison between Examples 9 and 10 and Examples 11 to 14 shows that, regardless of whether the thickness d_{A} of the first gate insulating film 21 is 300 nm or 2500 nm, a low variation ΔVth, high mobility, and a lower rate of reduction can be obtained. In particular, there was a tendency that the smaller the thickness d_{A} of the first gate insulating film 21, the lower the variation ΔVth, the higher the mobility, and the lower the rate of decrease in mobility. Therefore, when it is required to reduce the rate of decrease in mobility, the thickness d_{A} of the first gate insulating film 21 is preferably 1000 nm or less, more preferably 600 nm or less, and even more preferably 400 nm or less.

According to the above embodiments, the advantageous effects listed below can be obtained.
(1) With a structure satisfying Conditions 1 to 6, it is possible to reduce the variation in threshold voltage, increase the mobility of the semiconductor layer 13, and suppress the change in mobility caused by bending of the flexible substrate 11.
(2) When the dielectric property value K is 0.001 or higher and lower than 0.015, it is possible to obtain the effect of (1) above with a high mobility.

### [Reference Signs List]

C ... Channel region
L ... Channel length
11 ... Flexible substrate
11S ... Support surface
11S1 ... First part
11S2 ... Second part
12 ... Gate electrode layer
13 ... Semiconductor layer
14 ... Source electrode layer
15 ... Drain electrode layer
21 ... First gate insulating film
22 ... Second gate insulating film

## Claims

1. A thin film transistor comprising:
a flexible substrate (11) having a support surface (11S);
a gate electrode layer (12) located at a first part of the support surface;
a gate insulating layer (21, 22) covering a second part of the support surface and the gate electrode layer;
a semiconductor layer (13), the semiconductor layer and the gate electrode layer sandwiching the gate insulating layer;
a source electrode layer (14) in contact with a first end of the semiconductor layer; and
a drain electrode layer (15) in contact with a second end of the semiconductor layer,
wherein
the gate insulating layer includes
a first gate insulating film (21) formed of an organic polymer compound and covering the second part and the gate electrode layer, and
a second gate insulating film (22) formed of silicon nitride and sandwiched between the first gate insulating film and the semiconductor layer,
the second gate insulating film has a thickness of 2 nm or more and 30 nm or less, and
the second gate insulating film has a hydrogen content of 5 at% or more and 18 at% or less.

2. A thin film transistor comprising:
a flexible substrate (11) having a support surface (11S);
a gate electrode layer (12) located at a first part of the support surface;
a gate insulating layer (21, 22) covering a second part of the support surface and the gate electrode layer;
a semiconductor layer (13), the semiconductor layer and the gate electrode layer sandwiching the gate insulating layer;
a source electrode layer (14) in contact with a first end of the semiconductor layer; and
a drain electrode layer (15) in contact with a second end of the semiconductor layer,
wherein
the gate insulating layer includes
a first gate insulating film (21) formed of an organic polymer compound and covering the second part and the gate electrode layer, and
a second gate insulating film (22) formed of silicon oxide and sandwiched between the first gate insulating film and the semiconductor layer,
the second gate insulating film has a thickness of 5 nm or more and 25 nm or less, and
the second gate insulating film has a hydrogen content of 6 at% or more and 10 at% or less,

3. The thin film transistor according to any one of claims 1 or 2, wherein
the first gate insulating film has a relative permittivity ε_{A} and a thickness d_{A},
the second gate insulating film has a relative permittivity ε_{B} and a thickness d_{B}, and
the gate insulating layer satisfies a following formula (1)$0.001 \leq \left({ε}_{A}{/ d}_{A}\right) / \left({ε}_{B}{/ d}_{B}\right) < 0.015$ (1).

4. The thin film transistor according to any one of claims 1 to 3, wherein
a relative permittivity of the first gate insulating film is lower than a relative permittivity of the second gate insulating film, and
the first gate insulating film has a thickness of 300 nm or more and 2500 nm or less.

5. The thin film transistor according to any one of claims 1 to 4, wherein the semiconductor layer is an oxide semiconductor layer containing indium.

6. A method of manufacturing a thin film transistor, the method comprising:
forming a gate electrode layer (12) located at a first part of a support surface of a flexible substrate (11);
forming a gate insulating layer (21, 22) covering a second part of the support surface and the gate electrode layer;
forming a semiconductor layer (13), the semiconductor layer and the gate electrode layer sandwiching the gate insulating layer;
forming a source electrode layer (14) in contact with a first end of the semiconductor layer, and a drain electrode layer (15) in contact with a second end of the semiconductor layer,
wherein
the step of forming the gate insulating layer includes
forming a first gate insulating film (21) formed of an organic polymer compound and covering the second part and the gate electrode layer by a coating method, and
forming a second gate insulating film (22) formed of silicon oxide and sandwiched between the first gate insulating film and the semiconductor layer by plasma CVD,
the second gate insulating film has a thickness of 5 nm or more and 25 nm or less, and
the second gate insulating film has a hydrogen content of 6 at% or more and 10 at% or less.

7. A method of manufacturing a thin film transistor, the method comprising:
forming a gate electrode layer (12) located at a first part of a support surface of a flexible substrate (11);
forming a gate insulating layer (21, 22) covering a second part of the support surface and the gate electrode layer;
forming a semiconductor player (13), the semiconductor layer and the gate electrode layer sandwiching the gate insulating layer;
forming a source electrode layer (14) in contact with a first end of the semiconductor layer, and a drain electrode layer (15) in contact with a second end of the semiconductor layer,
wherein
the step of forming the gate insulating layer includes
forming a first gate insulating film (21) formed of an organic polymer compound and covering the second part and the gate electrode layer by a coating method, and
forming a second gate insulating film (22) formed of silicon nitride and sandwiched between the first gate insulating film and the semiconductor layer by plasma CVD,
the second gate insulating film has a thickness of 2 nm or more and 30 nm or less, and
the second gate insulating film has a hydrogen content of 5 at% or more and 18 at% or less.

## Patentansprüche

1. Dünnschichttransistor, umfassend:
ein flexibles Substrat (11), das eine Trägeroberfläche (11S) aufweist;
eine Gate-Elektrodenschicht (12), die an einem ersten Bereich der Trägeroberfläche angeordnet ist;
eine Gate-Isolierschicht (21, 22), die einen zweiten Bereich der Trägeroberfläche und die Gate-Elektrodenschicht bedeckt;
eine Halbleiterschicht (13), wobei die Gate-Isolierschicht zwischen der Halbleiterschicht und der Gate-Elektrodenschicht angeordnet ist;
eine Source-Elektrodenschicht (14), die mit einem ersten Ende der Halbleiterschicht in Kontakt steht; und
eine Drain-Elektrodenschicht (15), die mit einem zweiten Ende der Halbleiterschicht in Kontakt steht;
wobei die Gate-Isolierschicht umfasst:
einen ersten Gate-Isolierfilm (21), der aus einer organischen Polymerverbindung gebildet ist und den zweiten Bereich und die Gate-Elektrodenschicht bedeckt; und
einen zweiten Gate-Isolierfilm (22), der aus Siliziumnitrid gebildet ist und zwischen dem ersten Gate-Isolierfilm und der Halbleiterschicht angeordnet ist,
wobei der zweite Gate-Isolierfilm eine Dicke von mindestens 2 nm und höchstens 30 nm aufweist und
der zweite Gate-Isolierfilm einen Wasserstoffgehalt von mindestens 5 Atom-% und höchstens 18 Atom-% aufweist.

2. Dünnschichttransistor, umfassend:
ein flexibles Substrat (11), das eine Trägeroberfläche (11S) aufweist;
eine Gate-Elektrodenschicht (12), die an einem ersten Bereich der Trägeroberfläche angeordnet ist;
eine Gate-Isolierschicht (21, 22), die einen zweiten Bereich der Trägeroberfläche und die Gate-Elektrodenschicht bedeckt;
eine Halbleiterschicht (13), wobei die Gate-Isolierschicht zwischen der Halbleiterschicht und der Gate-Elektrodenschicht angeordnet ist;
eine Source-Elektrodenschicht (14), die mit einem ersten Ende der Halbleiterschicht in Kontakt steht; und
eine Drain-Elektrodenschicht (15), die mit einem zweiten Ende der Halbleiterschicht in Kontakt steht;
wobei die Gate-Isolierschicht umfasst:
einen ersten Gate-Isolierfilm (21), der aus einer organischen Polymerverbindung gebildet ist und den zweiten Bereich sowie die Gate-Elektrodenschicht bedeckt; und
einen zweiten Gate-Isolierfilm (22), der aus Siliziumoxid gebildet ist und zwischen dem ersten Gate-Isolierfilm und der Halbleiterschicht angeordnet ist,
wobei der zweite Gate-Isolierfilm eine Dicke von mindestens 5 nm und höchstens 25 nm aufweist und
der zweite Gate-Isolierfilm einen Wasserstoffgehalt von mindestens 6 Atom-% und höchstens 10 Atom-% aufweist.

3. Dünnschichttransistor nach einem der Ansprüche 1 oder 2, wobei
der erste Gate-Isolierfilm eine relative Permittivität ε_{A} und eine Dicke d_{A} aufweist,
der zweite Gate-Isolierfilm eine relative Permittivität ε_{B} und eine Dicke d_{B} aufweist und
die Gate-Isolierschicht die folgende Formel (1) erfüllt:$0.001 \leq \left({ε}_{A}{/ d}_{A}\right) / \left({ε}_{B}{/ d}_{B}\right) < 0.015$ (1).

4. Dünnschichttransistor nach einem der Ansprüche 1 bis 3, wobei
eine relative Permittivität des ersten Gate-Isolierfilms niedriger ist als eine relative Permittivität des zweiten Gate-Isolierfilms und
der erste Gate-Isolierfilm eine Dicke von mindestens 300 nm und höchstens 2500 nm aufweist.

5. Dünnschichttransistor nach einem der Ansprüche 1 bis 4, wobei die Halbleiterschicht eine Indium enthaltende Oxidhalbleiterschicht ist.

6. Verfahren zur Herstellung eines Dünnschichttransistors, wobei das Verfahren umfasst:
Ausbilden einer Gate-Elektrodenschicht (12), die an einem ersten Bereich einer Trägeroberfläche eines flexiblen Substrats (11) angeordnet ist;
Ausbilden einer Gate-Isolierschicht (21, 22), die einen zweiten Bereich der Trägeroberfläche und die Gate-Elektrodenschicht bedeckt;
Ausbilden einer Halbleiterschicht (13), wobei die Gate-Isolierschicht zwischen der Halbleiterschicht und der Gate-Elektrodenschicht angeordnet ist;
Ausbilden einer Source-Elektrodenschicht (14), die mit einem ersten Ende der Halbleiterschicht in Kontakt steht; und
Ausbilden einer Drain-Elektrodenschicht (15), die mit einem zweiten Ende der Halbleiterschicht in Kontakt steht,
wobei der Schritt des Ausbildens der Gate-Isolierschicht umfasst:
Ausbilden eines ersten Gate-Isolierfilms (21), der aus einer organischen Polymerverbindung gebildet ist und den zweiten Bereich sowie die Gate-Elektrodenschicht bedeckt, durch ein Beschichtungsverfahren; und
Ausbilden eines zweiten Gate-Isolierfilms (22), der aus Siliziumoxid gebildet ist und zwischen dem ersten Gate-Isolierfilm und der Halbleiterschicht angeordnet ist, mittels Plasma-CVD,
wobei der zweite Gate-Isolierfilm eine Dicke von mindestens 5 nm und höchstens 25 nm aufweist und der zweite Gate-Isolierfilm einen Wasserstoffgehalt von mindestens 6 Atom-% und höchstens 10 Atom-% aufweist.

7. Verfahren zur Herstellung eines Dünnschichttransistors, wobei das Verfahren umfasst:
Ausbilden einer Gate-Elektrodenschicht (12), die an einem ersten Bereich einer Trägeroberfläche eines flexiblen Substrats (11) angeordnet ist;
Ausbilden einer Gate-Isolierschicht (21, 22), die einen zweiten Bereich der Trägeroberfläche und die Gate-Elektrodenschicht bedeckt;
Ausbilden einer Halbleiterschicht (13), wobei die Gate-Isolierschicht zwischen der Halbleiterschicht und der Gate-Elektrodenschicht angeordnet ist;
Ausbilden einer Source-Elektrodenschicht (14), die mit einem ersten Ende der Halbleiterschicht in Kontakt steht; und
Ausbilden einer Drain-Elektrodenschicht (15), die mit einem zweiten Ende der Halbleiterschicht in Kontakt steht,
wobei der Schritt des Ausbildens der Gate-Isolierschicht umfasst:
Ausbilden eines ersten Gate-Isolierfilms (21), der aus einer organischen Polymerverbindung gebildet ist und den zweiten Bereich sowie die Gate-Elektrodenschicht bedeckt, durch ein Beschichtungsverfahren; und
Ausbilden eines zweiten Gate-Isolierfilms (22), der aus Siliziumnitrid gebildet ist und zwischen dem ersten Gate-Isolierfilm und der Halbleiterschicht angeordnet ist, mittels Plasma-CVD,
wobei der zweite Gate-Isolierfilm eine Dicke von mindestens 2 nm und höchstens 30 nm aufweist und der zweite Gate-Isolierfilm einen Wasserstoffgehalt von mindestens 5 Atom-% und höchstens 18 Atom-% aufweist.

## Revendications

1. Transistor à couches minces comprenant :
un substrat flexible (11) présentant une surface de support (11S) ;
une couche d'électrode grille (12) située au niveau d'une première partie de la surface de support ;
une couche isolante de grille (21, 22) recouvrant une seconde partie de la surface de support et la couche d'électrode grille ;
une couche semi-conductrice (13), la couche semi-conductrice et la couche d'électrode grille prenant en sandwich la couche isolante de grille ;
une couche d'électrode source (14) en contact avec une première extrémité de la couche semi-conductrice ; et
une couche d'électrode drain (15) en contact avec une seconde extrémité de la couche semi-conductrice,
dans lequel
la couche isolante de grille inclut
un premier film isolant de grille (21) formé d'un composé polymère organique et recouvrant la seconde partie et la couche d'électrode grille, et
un second film isolant de grille (22) formé de nitrure de silicium et pris en sandwich entre le premier film isolant de grille et la couche semi-conductrice,
le second film isolant de grille présente une épaisseur supérieure ou égale à 2 nm et inférieure ou égale à 30 nm, et
le second film isolant de grille présente une teneur en hydrogène supérieure ou égale à 5 % atomique et inférieure ou égale à 18 % atomique.

2. Transistor à couches minces comprenant :
un substrat flexible (11) présentant une surface de support (11S) ;
une couche d'électrode grille (12) située au niveau d'une première partie de la surface de support ;
une couche isolante de grille (21, 22) recouvrant une seconde partie de la surface de support et la couche d'électrode grille ;
une couche semi-conductrice (13), la couche semi-conductrice et la couche d'électrode grille prenant en sandwich la couche isolante de grille ;
une couche d'électrode source (14) en contact avec une première extrémité de la couche semi-conductrice ; et
une couche d'électrode drain (15) en contact avec une seconde extrémité de la couche semi-conductrice,
dans lequel
la couche isolante de grille inclut un premier film isolant de grille (21) formé d'un composé polymère organique et recouvrant la seconde partie et la couche d'électrode grille, et
un second film isolant de grille (22) formé d'oxyde de silicium et pris en sandwich entre le premier film isolant de grille et la couche semi-conductrice,
le second film isolant de grille présente une épaisseur supérieure ou égale à 5 nm et inférieure ou égale à 25 nm, et
le second film isolant de grille présente une teneur en hydrogène supérieure ou égale à 6 % atomique et inférieure ou égale à 10 % atomique,

3. Transistor à couches minces selon l'une quelconque des revendications 1 ou 2, dans lequel
le premier film isolant de grille présente une permittivité relative ε_{A} et une épaisseur d_{A},
le second film isolant de grille présente une permittivité relative ε_{B} et une épaisseur d_{B}, et
la couche isolante de grille satisfait à une formule (1) suivante$0.001 \leq \left({ε}_{A}{/ d}_{A}\right) / \left({ε}_{B}{/ d}_{B}\right) < 0.015$ (1).

4. Transistor à couches minces selon l'une quelconque des revendications 1 à 3, dans lequel
une permittivité relative du premier film isolant de grille est inférieure à une permittivité relative du second film isolant de grille, et
le premier film isolant de grille présente une épaisseur supérieure ou égale à 300 nm et inférieure ou égale à 2 500 nm.

5. Transistor à couches minces selon l'une quelconque des revendications 1 à 4, dans lequel la couche semi-conductrice est une couche semi-conductrice d'oxyde contenant de l'indium.

6. Procédé de fabrication d'un transistor à couches minces, le procédé comprenant :
la formation d'une couche d'électrode grille (12) située au niveau d'une première partie d'une surface de support d'un substrat flexible (11) ;
la formation d'une couche isolante de grille (21, 22) recouvrant une seconde partie de la surface de support et la couche d'électrode grille ;
la formation d'une couche semi-conductrice (13), la couche semi-conductrice et la couche d'électrode grille prenant en sandwich la couche isolante de grille ;
la formation d'une couche d'électrode source (14) en contact avec une première extrémité de la couche semi-conductrice, et d'une couche d'électrode drain (15) en contact avec une seconde extrémité de la couche semi-conductrice,
dans lequel
l'étape de formation de la couche isolante de grille inclut la formation d'un premier film isolant de grille (21) formé d'un composé polymère organique et recouvrant la seconde partie et la couche d'électrode grille par un procédé de revêtement, et
la formation d'un second film isolant de grille (22) formé d'oxyde de silicium et pris en sandwich entre le premier film isolant de grille et la couche semi-conductrice par CVD au plasma,
le second film isolant de grille présente une épaisseur supérieure ou égale à 5 nm et inférieure ou égale à 25 nm, et
le second film isolant de grille présente une teneur en hydrogène supérieure ou égale à 6 % atomique et inférieure ou égale à 10 % atomique.

7. Procédé de fabrication d'un transistor à couches minces, le procédé comprenant :
la formation d'une couche d'électrode grille (12) située au niveau d'une première partie d'une surface de support d'un substrat flexible (11) ;
la formation d'une couche isolante de grille (21, 22) recouvrant une seconde partie de la surface de support et la couche d'électrode grille ;
la formation d'une couche semi-conductrice (13), la couche semi-conductrice et la couche d'électrode grille prenant en sandwich la couche isolante de grille ;
la formation d'une couche d'électrode source (14) en contact avec une première extrémité de la couche semi-conductrice, et d'une couche d'électrode drain (15) en contact avec une seconde extrémité de la couche semi-conductrice,
dans lequel
l'étape de formation de la couche isolante de grille inclut la formation d'un premier film isolant de grille (21) formé d'un composé polymère organique et recouvrant la seconde partie et la couche d'électrode grille par un procédé de revêtement, et
la formation d'un second film isolant de grille (22) formé de nitrure de silicium et pris en sandwich entre le premier film isolant de grille et la couche semi-conductrice par CVD au plasma,
le second film isolant de grille présente une épaisseur supérieure ou égale à 2 nm et inférieure ou égale à 30 nm, et
le second film isolant de grille présente une teneur en hydrogène supérieure ou égale à 5 % atomique et inférieure ou égale à 18 % atomique.
